# EUROPEAN PATENT APPLICATION

(11) **EP 4 766 079 A1**
(43) Date of publication of application: **24.06.2026**
(21) Application number: 25184723.2
(22) Date of filing: 24.06.2025
(51) Int. Cl.: H10D 30/47, H10D 30/01, H10D 62/13

(54) **STRUCTURES FOR A HIGH-ELECTRON-MOBILITY TRANSISTOR**

(30) Priority: 17.12.2024 US 202418983487
(71) Applicant: GlobalFoundries U.S. Inc., Malta, NY 12020 (US)
(72) Inventor: Rassel, Richard, Essex Junction, VT 05452 (US); He, Zhong-Xiang, Essex Junction, VT 05452 (US); Milo, Gary, Essex Junction, VT 05452 (US); Hazbun, Ramsey, Essex Junction, VT 05452 (US)
(74) Representative: Grünecker Patent- und Rechtsanwälte PartG mbB

(57) **Abstract**

Structures for a high-electron-mobility transistor and methods of forming such structures. The structure comprises a layer stack including an active region, and a dielectric layer on the active region of the layer stack. The active region has a perimeter. The dielectric layer includes an opening and portions between the opening and the perimeter of the active region. The structure further comprises a source/drain region inside the opening in the dielectric layer.

## Description

### STATEMENT REGARDING FEDERALLY SPONSORED RESEARCH OR

### DEVELOPMENT

This invention was made with government support under HQ0727790700 awarded by the Defense Microelectronics Activity. The government has certain rights in the invention.

### BACKGROUND

The disclosure relates to semiconductor device fabrication and integrated circuits and, more specifically, to structures including for a high-electron-mobility transistor and methods of forming such structures.

Compound semiconductors are characterized by material properties, such as a carrier mobility that is greater than the carrier mobility of silicon and a wider band gap than silicon, that can be exploited. Compound semiconductors may include, for example, Group III elements (e.g., aluminum, gallium, and/or indium) and Group V elements (e.g., nitrogen, phosphorus, arsenic, and/or antimony) combined with the Group III elements.

High-electron-mobility transistors are compound semiconductor-based devices that may be deployed in certain integrated circuit applications, such as high-voltage power electronics. A high-electron-mobility transistor may include a heterojunction between crystalline compound semiconductor materials having different band gaps, such as a heterojunction between binary gallium nitride and trinary aluminum-gallium nitride. A two-dimensional electron gas, which is formed near an interface at the heterojunction, defines the channel of the high-electron-mobility transistor.

Improved structures for a high-electron-mobility transistor and methods of forming such structures are needed.

### SUMMARY

In an embodiment of the invention, a structure for a high-electron-mobility transistor is provided. The structure comprises a layer stack including an active region, and a dielectric layer on the active region of the layer stack. The active region has a perimeter. The dielectric layer includes an opening and portions between the opening and the perimeter of the active region. The structure further comprises a source/drain region inside the opening in the dielectric layer.

In an embodiment of the invention, a method of forming a structure for a high-electron-mobility transistor is provided. The method comprises forming a layer stack including an active region that has a perimeter, forming a dielectric layer that includes an opening and a plurality of portions between the opening the perimeter of the layer stack, and forming a source/drain region inside an opening in the dielectric layer.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIG. 1 is a top view of a structure at an initial fabrication stage of a processing method in accordance with embodiments of the invention.
FIG. 1A is a cross-sectional view taken generally along line 1A-1A in FIG. 1.
FIG. 2 is a top view of the structure at a fabrication stage subsequent to FIGS. 1, 1A.
FIG. 2A is a cross-sectional view taken generally along line 2A-2A in FIG. 2.
FIG. 3 is a top view of the structure at a fabrication stage subsequent to FIGS. 2, 2A.
FIG. 3A is a cross-sectional view taken generally along line 3A-3A in FIG. 3.
FIG. 4 is a top view of the structure at a fabrication stage subsequent to FIGS. 3, 3A.
FIG. 4A is a cross-sectional view taken generally along line 4A-4A in FIG. 4.
FIG. 5 is a cross-sectional view of the structure at a fabrication stage subsequent to FIGS. 4, 4A.

### DETAILED DESCRIPTION

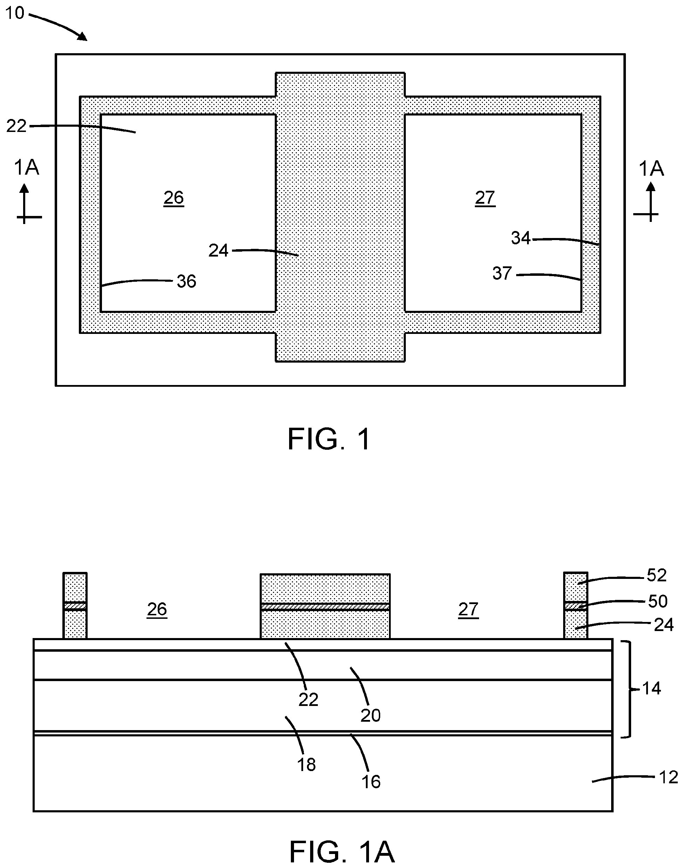

With reference to FIGS. 1, 1A and in accordance with embodiments of the invention, a structure 10 for a high-electron-mobility transistor may include a layer stack 14 that is formed on the top surface of a substrate 12. The substrate 12 may be comprised of a single-crystal semiconductor material, such as single-crystal silicon. The substrate 12 may be a bulk substrate that contains a single-crystal semiconductor material, such as single-crystal silicon. In an embodiment, the single-crystal semiconductor material of the substrate 12 may have a crystal lattice structure with a <111> crystal orientation. The substrate 12 may be doped to have, for example, p-type conductivity.

The layer stack 14 may include a seed layer 16, a buffer layer 18, a channel layer 20, and a donor layer 22 each containing one or more compound semiconductor materials. The layers 16, 18, 20, 22 may be serially deposited using an epitaxial growth process, such as metalorganic chemical vapor deposition, vapor phase epitaxy, or molecular beam epitaxy, to form the layer stack 14. The layer stack 14 may have a thickness, for example, on the order of about one (1) micrometer to about five (5) micrometers.

The layers 16, 18, 20, 22 of the layer stack 14 may each have a crystal structure that is single crystal or, alternatively, a crystal structure that is substantially single crystal with varying levels of crystalline defectivity present. The seed layer 16 provides a thin nucleation layer for the growth of the buffer layer 18 and may be comprised of, for example, aluminum nitride. The buffer layer 18 may be comprised of one or more binary or ternary III-V compound semiconductor materials, such as gallium nitride, aluminum nitride, aluminum gallium nitride, or a layered combination of these materials, and the buffer layer 18 may be tailored in terms of material composition, doping, layering, and/or layer thickness to accommodate lattice mismatch, thermal property differences, and mechanical property differences between the material of the substrate 12 and the material of the channel layer 20. The channel layer 20, which overlies the buffer layer 18, may be comprised of a binary or ternary **III-V** compound semiconductor material. The donor layer 22, which overlies the channel layer 20, may contain a ternary III-V compound semiconductor, such as aluminum gallium nitride or indium aluminum nitride, that provides an heterogenous interface with the channel layer 20 of different composition. The channel layer 20 may include a sublayer comprised of undoped gallium nitride adjacent to the donor layer 22 and a sublayer comprised of gallium nitride doped with either carbon, aluminum, or iron adjacent to the buffer layer 18, and an optional barrier layer comprised of, for example, aluminum nitride may be located between the channel layer 20 and the donor layer 22. Due to the polarization fields inherent in the material a two-dimensional electron gas with high charge density and high mobility is formed near an interface at the heterojunction between the channel layer 20 and the donor layer 22.

A dielectric layer 24, a dielectric layer 50, and a dielectric layer 52 may be deposited on the layer stack 14 and patterned by lithography and etching processes to define an opening 26 and an opening 27 arranged over different portions of the layer stack 14. The dielectric layer 24 may be disposed in direct contact with the upper surface of the layer stack 14. In an embodiment, the dielectric layer 24 and the dielectric layer 52 may be comprised of a dielectric material, such as silicon nitride, that is an electrical insulator. The dielectric layer 50 may be comprised of a material, such as aluminum oxide, that can function as an etch stop when etching the dielectric materials constituting the dielectric layer 24 and the dielectric layer 52.

The openings 26, 27 may extend fully through the dielectric layer 24, the dielectric layer 50, and the dielectric layer 52. The patterned dielectric layer 24 has a perimeter 34, the opening 26 has a perimeter 36, and strip portions of the patterned dielectric layer 24 are arranged between the perimeter 34 and the perimeter 36. The opening 27 has a perimeter 37, and strip portions of the patterned dielectric layer 24 are arranged between the perimeter 34 and the perimeter 37. The strip portions of the dielectric layer 24 overlap with, and overlie, portions of the layer stack 14. A region of the layer stack 14 laterally between the opening 26 and the opening 27 is covered by the dielectric layer 24. The dielectric layers 50, 52 have strip portions aligned with the strip portions of the dielectric layer 24 because the openings 26, 27 also penetrate through the dielectric layers 50, 52.

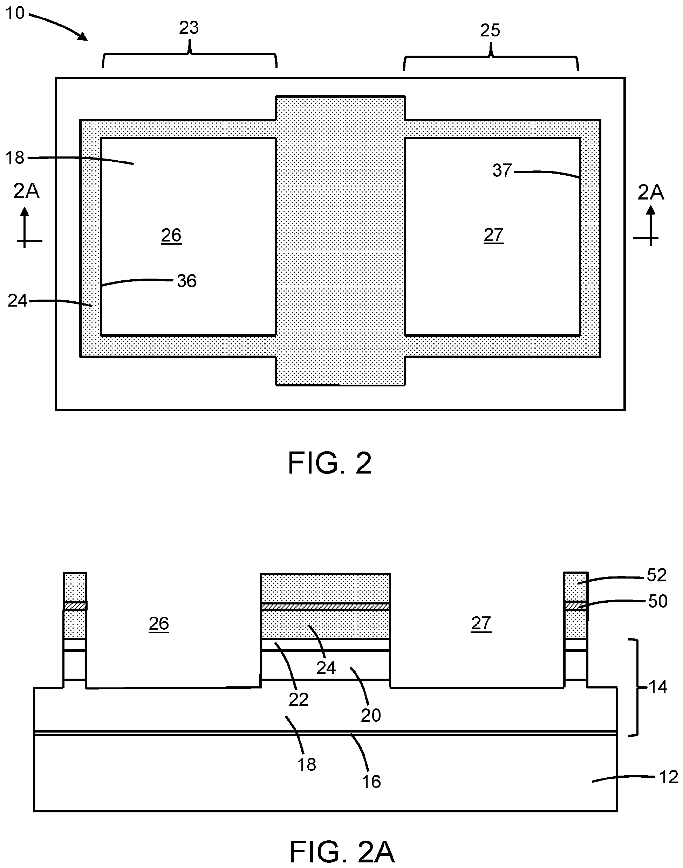

With reference to FIGS. 2, 2A in which like reference numerals refer to like features in FIGS. 1, 1A and at a subsequent fabrication stage, regions 23, 25 of the layer stack 14 that are not covered by the patterned dielectric layer 24 are recessed using the patterned dielectric layer 24 as a hardmask. The recessed region 23 spatially coincides with the opening 26 such that the perimeter 36 of the opening 26 is extended in depth into the layer stack 14. The recessed region 25 spatially coincides with the opening 27 such that the perimeter 37 of the opening 27 is extended in depth into the layer stack 14. Regions of the layer stack 14 outside of the perimeter 34 of the patterned dielectric layer 24 are also recessed. The recessed region 23 is surrounded by non-recessed regions of the layer stack 14 that are covered by the strip portions of the patterned dielectric layer 24, and the recessed region 25 is surrounded by non-recessed regions of the layer stack 14 that are covered by the strip portions of the patterned dielectric layer 24.

The recessed regions 23, 25 extend to a maximum depth into the layer stack 14 relative to a top surface of the donor layer 22. In an embodiment, the etching process may remove portions of the channel layer 20 and donor layer 22 in the recessed regions 23, 25 and the recessing may extend into the buffer layer 18 in the recessed regions. In an alternative embodiment, the etching process may remove portions of donor layer 22 and the recessing may extend partially through the channel layer 20 in the recessed regions 23, 25. In an alternative embodiment, the recessing may extend partially through the donor layer 22 in the recessed regions 23, 25.

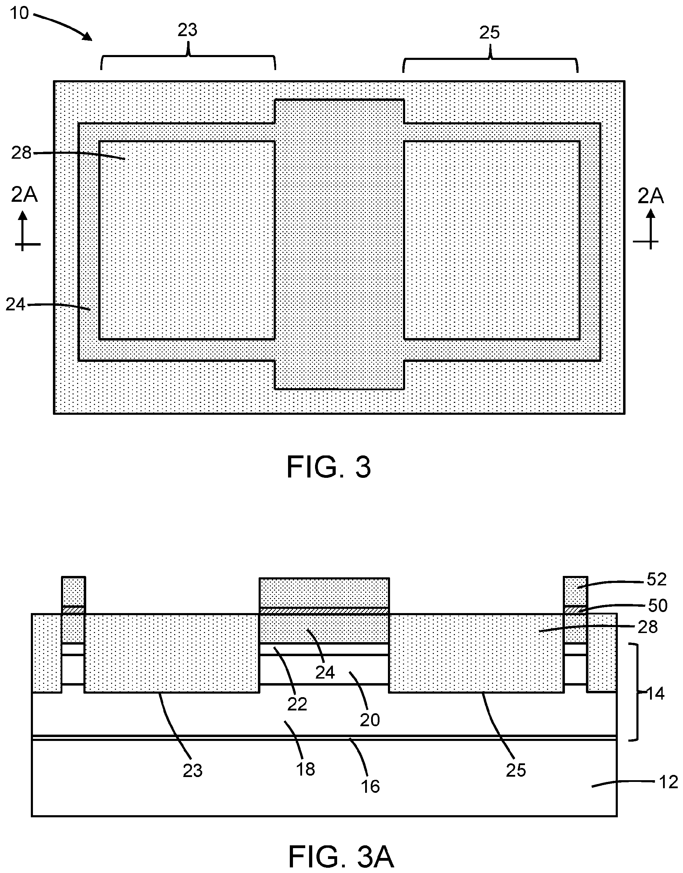

With reference to FIGS. 3, 3A in which like reference numerals refer to like features in FIGS. 2, 2A and at a subsequent fabrication stage, a semiconductor layer 28 may be formed that includes a portion on the recessed region 23 of the layer stack 14 and inside the opening 26 (FIGS. 2, 2A) in the patterned dielectric layer 24, a portion on the recessed region 25 of the layer stack 14 and inside the opening 27 (FIGS. 2, 2A) in the patterned dielectric layer 24, and portions on the recessed regions of the layer stack 14 surrounding the patterned dielectric layer 24. In an embodiment, the semiconductor layer 28 may be comprised of a binary or ternary III-V compound semiconductor material, such as n-doped gallium nitride or indium-gallium-nitride, that is formed by an epitaxial growth process. The III-V compound semiconductor material may be in situ doped during epitaxial growth with, for example, an n-type dopant such as silicon or germanium. The dielectric material of the dielectric layer 24 blocks the epitaxial growth of semiconductor material of the semiconductor layer 28 on non-recessed regions of the layer stack 14 that are covered by the dielectric layer 24. In that regard, the dielectric material of the patterned dielectric layer 24 provides a template for the epitaxial growth that includes a frame surrounding the portion of the semiconductor layer 28 on the recessed region 23 and inside the opening 26, and an adjacent frame surrounding the portion of the semiconductor layer 28 on the recessed region 25 and inside the opening 27. In an embodiment, the portions of the semiconductor layer 28 on the recessed regions 23, 25 of the layer stack 14 may be substantially coplanar with the patterned dielectric layer 24 surrounding the openings 26, 27. In an alternative embodiment, the portions of the semiconductor layer 28 on the recessed regions 23, 25 of the layer stack 14 may be substantially coplanar with the donor layer 22 surrounding the openings 26, 27.

The portion of the semiconductor layer 28 on the recessed region 23 may have the same cross-sectional area as the opening 26 and may be coextensive with the perimeter 36 of the opening 26, which establishes the sidewalls of the portion of the semiconductor layer 28. The portion of the semiconductor layer 28 on the recessed region 25 may have the same cross-sectional area as the opening 27 and may be coextensive with the perimeter 37 of the opening 27, which establishes the sidewalls of the portion of the semiconductor layer 28. In an embodiment, the portions of the semiconductor layer 28 on the recessed regions 23, 25 may provide source/drain regions of the high-electron-mobility transistor in which one portion constitutes a source and the other portion constitutes a drain. In an embodiment, the portion of the semiconductor layer 28 on the recessed region 23 may provide a source of the high-electron-mobility transistor, and the portion of the semiconductor material of the semiconductor layer 28 on the recessed region 25 may provide a drain of the high-electron-mobility transistor.

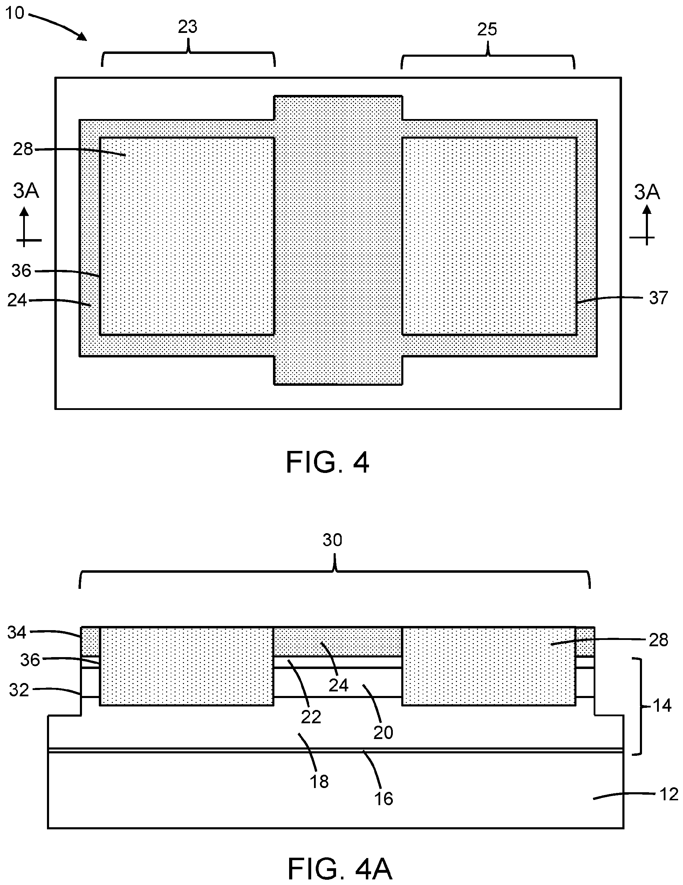

With reference to FIGS. 4, 4A in which like reference numerals refer to like features in FIGS. 3, 3A and at a subsequent fabrication stage, the semiconductor layer 28 may be patterned by lithography and etching processes to define an active region 30 of the layer stack 14. The etching process may further recess the layer stack 14 and, in that regard, may establish a perimeter 32 of the active region 30. The patterned dielectric layer 24 and the portions of the semiconductor layer 28 on the recessed regions 23, 25 of the layer stack 14 may be protected by a lithographically-formed resist mask during the etching process. The perimeter 34 of the patterned dielectric layer 24 spatially coincides with the perimeter 32 of the active region 30. The semiconductor layer 28 is removed outside of the perimeter 32 of the active region 30. The removal of the semiconductor layer 28 and the recessing of the layer stack 14 provide mesa isolation that isolates the active region 30 from neighboring active regions. The dielectric layers 50, 52 may be removed after patterning the semiconductor layer 28.

The etching process may be a reactive ion etching process that removes the semiconductor material of the semiconductor layer 28 selective to the dielectric material of the dielectric layer 24. As used herein, the term "selective" in reference to a material removal process (e.g., etching) denotes that, with an appropriate etchant choice, the material removal rate (i.e., etch rate) for the targeted material is greater than the removal rate for at least another material exposed to the material removal process. The reactive ion etching process may be performed by employing a plasma of energetic reactive ions that are selected to chemically provide the etch selectivity.

The layer stack 14 includes a non-recessed region that is laterally positioned between the portion of the semiconductor layer 28 inside the perimeter 36 of the opening 26 and the perimeter 32 of the active region 30, and the non-recessed region is overlapped by the portion of the patterned dielectric layer 24 surrounding the opening 26. The layer stack 14 includes a non-recessed region that is laterally positioned between the portion of the semiconductor layer 28 inside the perimeter 37 of the opening 27 and the perimeter 32 of the active region 30, and the non-recessed region is overlapped by the portion of the patterned dielectric layer 24 surrounding the opening 27. A non-recessed region of the layer stack 14 is also preserved laterally between the portion of the semiconductor layer 28 inside the opening 26 and the portion of the semiconductor layer 28 inside the opening 27.

The dielectric layer 24 provides strips of dielectric material that are positioned between the portions of the semiconductor layer 28 inside the openings 26, 27 and the perimeter 32 of the active region 30. Because the patterned dielectric layer 24 is formed before epitaxially growing the semiconductor layer 28 and includes frames of dielectric material that surround the openings 26, 27, the patterning that defines the active region 30 is not required to remove the excess semiconductor material of the semiconductor layer 28 at the perimeter 32 of the active region 30. Plasma charge damage to the active region 30 from the reactive ion etching process may be mitigated by the frames of dielectric material surrounding the portions of the semiconductor material of the semiconductor layer 28 on the recessed regions 23, 25. The plasma charge damage, if not mitigated by the dielectric layer 24, may also increase leakage and/or degrade the channel for the two-dimensional electron gas.

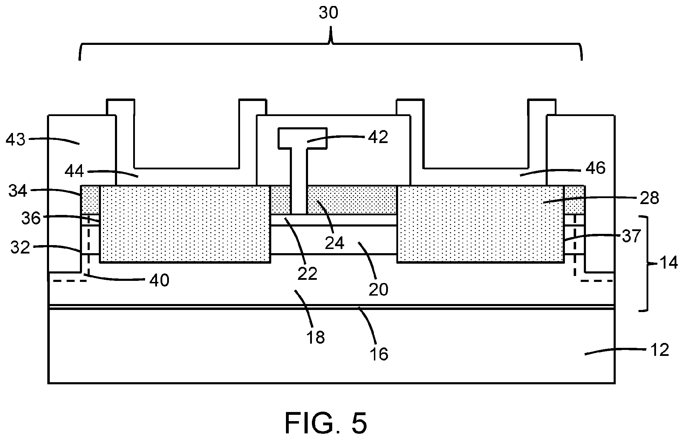

With reference to FIG. 5 in which like reference numerals refer to like features in FIGS. 4, 4A and at a subsequent fabrication stage, an isolation region 40 may be formed that surrounds the perimeter 32 of the active region 30. The isolation region 40 may be formed by, for example, a masked implantation of, for example, nitrogen that damages the crystal lattice structure of the layer stack 14. The isolation region 40 may include a portion inside the layer stack 14 that extends fully through the donor layer 22 and channel layer 20. The portion of the isolation region 40 inside the layer stack 14 is located adjacent to the perimeter 32 of the active region 30. One portion of the isolation region 40 inside the layer stack 14 is laterally positioned between the portion of the semiconductor layer 28 on the recessed region 23 inside the opening 26 and the perimeter 32 of the active region 30. Another portion of the isolation region 40 inside the layer stack 14 is laterally positioned between the portion of the semiconductor layer 28 on the recessed region 25 inside the opening 26 and the perimeter 32 of the active region 30. The isolation region 40 interrupts the continuity of the two-dimensional electron gas.

The high-electron-mobility transistor embodied in the structure 10 may further include a gate 42 formed in a dielectric layer 43, a source ohmic contact 44, and a drain ohmic contact 46. The source ohmic contact 44 may contact the portion of the semiconductor layer 28 inside the opening 26, and an upper portion of the source ohmic contact 44 may overlap with a portion of the dielectric layer 43. The drain ohmic contact 46 may contact the portion of the semiconductor layer 28 inside the opening 27, and an upper portion of the drain ohmic contact 46 may overlap with a portion of the dielectric layer 43.

The gate 42 may be formed on a non-recessed portion of the layer stack 14 and over a channel for the two-dimensional electron gas in the layer stack 14. The channel for the two-dimensional electron gas is arranged in the layer stack 14 in a lateral direction between the different portions of the semiconductor layer 28 inside the openings 26, 27. A portion of the gate 42 may extend through a portion of the dielectric layer 24 to the layer stack 14. The gate 42 is positioned in a lateral direction between the source ohmic contact 44 and the drain ohmic contact 46. In an embodiment, the source ohmic contact 44 and the drain ohmic contact 46 may be in a directly contacting relationship with the portions of the semiconductor layer 28 inside the openings 26, 27.

The gate 42 may be comprised of one or more metals, such as titanium nitride and aluminum or tungsten, or alternatively copper. The dielectric layer 43 may be comprised of a **dielectric** material, such as silicon dioxide. The source ohmic contact 44 and the drain ohmic contact 46 be comprised of one or more metals, which may include titanium and aluminum that may be annealed to form a polycrystalline alloy.

Middle-of-line processing and back-end-of-line processing follow, which includes formation of field plates, contacts, vias, and wiring for an interconnect structure coupled to the gate 42, the source ohmic contact 44, and the drain ohmic contact 46 of the high-electron-mobility transistor embodied in the structure 10.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value or precise condition as specified. **In** embodiments, language of approximation may indicate a range of +/-10% of the stated value(s) or the stated condition(s).

References herein to terms such as "vertical", "horizontal", etc. are made by way of example, and not by way of limitation, to establish a frame of reference. The term "horizontal" as used herein is defined as a direction or a plane parallel to a conventional plane of a semiconductor substrate, regardless of its actual three-dimensional spatial orientation. The terms "vertical" and "normal" refer to a direction in the frame of reference perpendicular to the horizontal plane, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features may "overlap" if a feature extends over, and covers a part of, another feature. A feature may "overlie" another feature if a feature is positioned "over" another feature in a vertical direction.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

**In** summary, structures for a high-electron-mobility transistor and methods of forming such structures are disclosed. The structure comprises a layer stack including an active region, and a dielectric layer on the active region of the layer stack. The active region has a perimeter. The dielectric layer includes an opening and portions between the opening and the perimeter of the active region. The structure further comprises a source/drain region inside the opening in the dielectric layer.

The following embodiments are explicitly disclosed.

### Embodiment 1:

A structure for a high-electron-mobility transistor, the structure comprising:
a layer stack including an active region, the active region having a first perimeter;
a first dielectric layer on the active region of the layer stack, the first dielectric layer including a first opening and a first plurality of portions between the first opening and the first perimeter of the active region; and
a first source/drain region inside the first opening in the first dielectric layer.

### Embodiment 2:

The structure of embodiment 1, further comprising:
a first ohmic contact coupled to the first source/drain region.

### Embodiment 3:

The structure of embodiment 2, wherein the first dielectric layer comprises a first dielectric material, and further comprising:
a second dielectric layer on the first dielectric layer, the second dielectric layer including a second opening aligned with the first source/drain region, the first ohmic contact is positioned inside the second opening, and the second dielectric layer comprises a second dielectric material different from the first dielectric material.

### Embodiment 4:

The structure of embodiment 3, wherein the first dielectric material is silicon nitride, and the second dielectric material is silicon dioxide.

### Embodiment 5:

The structure of embodiment 3 or 4, wherein the second dielectric layer overlaps with the first source/drain region and the first dielectric layer.

### Embodiment 6:

The structure of one of embodiments 1 to 5, wherein the first dielectric layer includes a second opening and a second plurality of portions between the second opening and the first perimeter of the active region, and further comprising:
a second source/drain region inside the second opening in the first dielectric layer.

### Embodiment 7:

The structure of one of embodiments 1 to 6, further comprising:
a first ohmic contact coupled to the first source/drain region; and
a second ohmic contact coupled to the second source/drain region.
**In** some illustrative examples of embodiment 7, embodiment 7 may refer back to embodiment 6.

### Embodiment 8:

The structure of one of embodiments 1 to 7, wherein the layer stack includes a first recessed region and a second recessed region, the first recessed region spatially coincides with the first opening, the second recessed region spatially coincides with the second opening, and the first source/drain region and the second source/drain region comprise respective portions of a semiconductor layer positioned on the first recessed region and the second recessed region.
**In** some illustrative examples of embodiment 8, embodiment 8 may refer back to embodiment 6 or 7.

### Embodiment 9:

The structure of one of embodiments 1 to 8, further comprising:
a gate on a non-recessed portion of the layer stack, the gate between the first source/drain region and the second source/drain region.
**In** some illustrative examples of embodiment 9, embodiment 9 may refer back to embodiment 8.

### Embodiment 10:

The structure of one of embodiments 1 to 9, wherein the gate extends through the first dielectric layer to a portion of the layer stack.
**In** some illustrative examples of embodiment 10, embodiment 10 may refer back to embodiment 9.

### Embodiment 11:

The structure of one of embodiments 1 to 10, wherein the first dielectric layer comprises silicon nitride.

### Embodiment 12:

The structure of one of embodiments 1 to 11, wherein the layer stack includes a plurality of semiconductor layers each comprising a compound semiconductor material.

### Embodiment 13:

The structure of one of embodiments 1 to 12, wherein the first source/drain region comprises indium-gallium-nitride.

### Embodiment 14:

The structure of one of embodiments 1 to 13, wherein the first dielectric layer has a second perimeter, and the second perimeter of the first dielectric layer spatially coincides with the first perimeter of the active region.

### Embodiment 15:

The structure of one of embodiments 1 to 14, wherein the first plurality of portions of the first dielectric layer are positioned between the first opening and the second perimeter of the first dielectric layer.
In some illustrative examples of embodiment 15, embodiment 15 may refer back to embodiment 14.

### Embodiment 16:

The structure of one of embodiments 1 to 15, wherein the first plurality of portions of the first dielectric layer surround the first opening in the first dielectric layer.
In some illustrative examples of embodiment 16, embodiment 16 may refer back to embodiment 15.

### Embodiment 17:

The structure of one of embodiments 1 to 16 wherein the first plurality of portions extend from the second perimeter of the first dielectric layer to the first opening in the first dielectric layer.
In some illustrative examples of embodiment 17, embodiment 17 may refer back to embodiment 15 or 16.

### Embodiment 18:

The structure of one of embodiments 1 to 17, further comprising:
an isolation region including a portion inside the layer stack adjacent to the first perimeter.

### Embodiment 19:

The structure of embodiment 18, wherein the portion of the isolation region is laterally positioned between the first source/drain region and the first perimeter.

### Embodiment 20:

A method of forming a structure for a high-electron-mobility transistor, the method comprising:
forming a layer stack including an active region, wherein the active region has a perimeter;
forming a dielectric layer including an opening and a plurality of portions between the opening and the perimeter of the active region of the layer stack; and
forming a source/drain region inside the opening in the dielectric layer.

### Embodiment 21:

The method of embodiment 20, wherein the structure of one of embodiments 1 to 19 is formed.

## Claims

1. A structure for a high-electron-mobility transistor, the structure comprising:
a layer stack including an active region, the active region having a first perimeter;
a first dielectric layer on the active region of the layer stack, the first dielectric layer including a first opening and a first plurality of portions between the first opening and the first perimeter of the active region; and
a first source/drain region inside the first opening in the first dielectric layer.

2. The structure of claim 1, further comprising:
a first ohmic contact coupled to the first source/drain region.

3. The structure of claim 2, wherein the first dielectric layer comprises a first dielectric material, and further comprising:
a second dielectric layer on the first dielectric layer, the second dielectric layer including a second opening aligned with the first source/drain region, the first ohmic contact is positioned inside the second opening, and the second dielectric layer comprises a second dielectric material different from the first dielectric material.

4. The structure of claim 3, wherein the first dielectric material is silicon nitride, and the second dielectric material is silicon dioxide, and/or
wherein the second dielectric layer overlaps with the first source/drain region and the first dielectric layer.

5. The structure of one of claims 1 to 4, wherein the first dielectric layer includes a second opening and a second plurality of portions between the second opening and the first perimeter of the active region, and further comprising:
a second source/drain region inside the second opening in the first dielectric layer.

6. The structure of one of claims 1 to 5, further comprising:
a first ohmic contact coupled to the first source/drain region; and
a second ohmic contact coupled to the second source/drain region.

7. The structure of one of claims 1 to 6, wherein the layer stack includes a first recessed region and a second recessed region, the first recessed region spatially coincides with the first opening, the second recessed region spatially coincides with the second opening, and the first source/drain region and the second source/drain region comprise respective portions of a semiconductor layer positioned on the first recessed region and the second recessed region.

8. The structure of one of claims 1 to 7, further comprising:
a gate on a non-recessed portion of the layer stack, the gate between the first source/drain region and the second source/drain region,
wherein the gate preferably extends through the first dielectric layer to a portion of the layer stack.

9. The structure of one of claims 1 to 8, wherein the first dielectric layer comprises silicon nitride, and/or
wherein the layer stack includes a plurality of semiconductor layers each comprising a compound semiconductor material.

10. The structure of one of claims 1 to 9, wherein the first source/drain region comprises indium-gallium-nitride.

11. The structure of one of claims 1 to 10, wherein the first dielectric layer has a second perimeter, and the second perimeter of the first dielectric layer spatially coincides with the first perimeter of the active region.

12. The structure of one of claims 1 to 11, wherein the first plurality of portions of the first dielectric layer are positioned between the first opening and the second perimeter of the first dielectric layer.

13. The structure of one of claims 1 to 12 wherein the first plurality of portions of the first dielectric layer surround the first opening in the first dielectric layer, and/or
wherein the first plurality of portions extend from the second perimeter of the first dielectric layer to the first opening in the first dielectric layer.

14. The structure of one of claims 1 to 13, further comprising:
an isolation region including a portion inside the layer stack adjacent to the first perimeter,
wherein the portion of the isolation region preferably is laterally positioned between the first source/drain region and the first perimeter.

15. A method of forming a structure for a high-electron-mobility transistor, the method comprising:
forming a layer stack including an active region, wherein the active region has a perimeter;
forming a dielectric layer including an opening and a plurality of portions between the opening and the perimeter of the active region of the layer stack; and
forming a source/drain region inside the opening in the dielectric layer.
